# EUROPEAN PATENT APPLICATION

(11) **EP 4 641 349 A1**
(43) Date of publication of application: **29.10.2025**
(21) Application number: 25162512.5
(22) Date of filing: 10.03.2025
(51) Int. Cl.: G06F 1/16, H10K 59/80, H10K 50/87, G02F 1/1333

(54) **DISPLAY DEVICE AND ELECTRONIC DEVICE**

(30) Priority: 25.04.2024 KR 20240055158
(71) Applicant: Samsung Display Co., Ltd., Yongin-si, Gyeonggi-do 17113 (KR)
(72) Inventor: Soh, Yong Kwon, Giheung-gu, Yongin-si, Gyeonggi-do (KR)
(74) Representative: Dr. Weitzel & Partner

(57) **Abstract**

The present invention relates to a display device, and more particularly to a display device that can efficiently dissipate heat from a driver circuit, and an electronic device including the same. According to an aspect of the present invention, there is provided a display device including: a display panel; a first driver circuit connected to the display panel; and a support plate overlapping with the display panel. The support plate may have a groove or a hole that overlaps with the first driver circuit.

## Description

The present invention relates to a display device, and more particularly to a display device that can efficiently dissipate heat from a driver circuit, and an electronic device including the same.

### 2. Description of the Related Art

An organic light-emitting diode display, unlike a liquid-crystal display, is self-luminous. Accordingly, an organic light-emitting diode display may be implemented without a separate light source and thus can be made lighter and thinner. An organic light-emitting diode display may have high-quality characteristics such as, for example, low power consumption, high luminance, and fast response speed, and thus is attracting attention as the next generation display.

### SUMMARY

Aspects of the present invention provide a display device that can efficiently dissipate heat from a driver circuit, and an electronic device including the same.

According to an aspect of the present invention, there is provided a display device including: a display panel; a first driver circuit connected to the display panel; and a support plate overlapping with the display panel. The support plate may have a groove or a hole that overlaps with the first driver circuit.

The groove or hole of the support plate may be defined by sidewalls of the support plate and a bottom of the support plate, and the groove or hole of the support plate and the sidewalls of the support plate may have different widths.

A width of the groove or hole of the support plate may be greater than a width of the sidewalls of the support plate.

A width of the groove or hole of the support plate may be smaller than a width of the sidewalls of the support plate.

The display device may further include: a second driver circuit connected to the display panel, and the groove or hole of the support plate may overlap with the second driver circuit. According to an alternative embodiment, the groove or hole of the support plate may be disposed around the second driver circuit when viewed from a top of the support plate.

The display device may further include: a circuit board connected to the display panel, and the first driver circuit may be disposed on the circuit board.

According to another aspect of the present invention, there is provided a display device including: a display panel; a first driver circuit connected to the display panel; and a support plate overlapping with the display panel. The support plate may have a groove or a hole that is disposed around the first driver circuit when viewed from a top of the support plate.

The groove or hole of the support plate may be defined by sidewalls of the support plate and a bottom of the support plate, and a width of the groove or hole of the support plate may be different from a width of the sidewalls of the support plate.

A width of the groove or hole of the support plate may be smaller than a width of the sidewalls of the support plate.

The first driver circuit may overlap with sidewalls of the support plate.

The display device may further include: a second driver circuit connected to the display panel, and the groove or hole of the support plate may overlap with the second driver circuit or may be disposed around the second driver circuit when viewed from a top of the support plate.

According to yet another aspect of the present invention, there is provided a display device including: a display panel; a first driver circuit connected to the display panel; a support plate overlapping with the display panel and having a groove or hole overlapping with the first driver circuit; and a heat dissipation member disposed in the groove or the hole of the support plate.

An edge of the groove or hole of the support plate may surround the heat dissipation member and the first driver circuit when viewed from a top of the support plate.

The heat dissipation member may overlap with the first driver circuit.

The display device may further include: a second driver circuit connected to the display panel, and an edge of the groove or hole of the support plate may surround the first driver circuit, the second driver circuit and the heat dissipation member when viewed from a top of the support plate.

The support plate may include sidewalls and a bottom defining the groove or hole, and the display device may further include a first adhesive layer disposed between the heat dissipation member and the bottom of the support plate.

The display device may further include: a circuit board connected to the display panel; and a second adhesive layer disposed between the heat dissipation member and the circuit board, wherein the first driver circuit is disposed on the circuit board.

The display device may further include: a reinforcement plate disposed between the support plate and the display panel; and a second adhesive layer disposed between the reinforcement plate and the heat dissipation member and between the circuit board and the heat dissipation member.

The second adhesive layer may be further disposed between the support plate and the reinforcement plate and between the support plate and the circuit board.

According to still another aspect of the present invention, there is provided a display device including: a display panel; a driver circuit on a mounting area of the display panel; a support plate disposed between a display area and the mounting area of the display panel; a reinforcement plate disposed between the support plate and the mounting area of the display panel; and a first adhesive layer between the reinforcement plate and the support plate, wherein the reinforcement plate has one of a groove, a hole and a slit on a surface facing the support plate, and wherein the first adhesive layer is disposed between the surface of the reinforcement plate and the support plate such that the first adhesive layer overlaps with none of the groove, the hole, and the slit. The first adhesive layer may also be termed as an upper adhesive layer.

The driver circuit may overlap with one of the groove, the hole, and the slit of the reinforcement plate.

The display device may further include: a second adhesive layer disposed between another surface of the reinforcement plate and the mounting area of the display panel. The second adhesive layer may also be termed as a lower adhesive layer.

The second adhesive layer may overlap with one of the groove, the hole, and the slit of the reinforcement plate.

The second adhesive layer may further overlap with the first adhesive layer.

According to still another aspect of the present invention, there is provided an electronic device including: a bottom cover; a cover window on the bottom cover; and a display device between the bottom cover and the cover window. The display device may include: a display panel; a first driver circuit connected to the display panel; and a support plate overlapping with the display panel, and the support plate may have a groove or a hole that overlaps with the first driver circuit.

The groove or hole of the support plate may be defined by sidewalls of the support plate and a bottom of the support plate, and a width of the groove or hole of the support plate may be different from a width of the sidewalls of the support plate.

A width of the groove or hole of the support plate may be greater than a width of the sidewalls of the support plate.

A width of the groove or hole of the support plate may be smaller than a width of the sidewalls of the support plate.

The electronic device may further include: a second driver circuit connected to the display panel, and the groove or hole of the support plate may overlap with the second driver circuit. According to an alternative embodiment, the groove or hole of the support plate may be disposed around the second driver circuit when viewed from a top of the support plate.

The electronic device may further include: a circuit board connected to the display panel, and the first driver circuit may be disposed on the circuit board.

According to an embodiment of the present invention, heat from a driver circuit can be efficiently dispersed in a display device and an electronic device. Accordingly, heat dissipation effect of the display device can be improved.

The effects according to the embodiments of the present invention are not limited to those mentioned above and more various effects are included in the following description of the present invention.

### BRIEF DESCRIPTION OF THE DRAWINGS

The above and other aspects and features of the present invention will become more apparent by describing in detail example embodiments thereof with reference to the attached drawings, in which:
FIG. 1 is a plan view of a display device according to an embodiment of the present invention.
FIG. 2 is a cross-sectional view taken along line I - I' of FIG. 1.
FIG. 3 is a perspective view of a part of a support plate of FIGS. 1 and 2.
FIG. 4 is a view for illustrating the display panel of FIG. 2.
FIG. 5 is a plan view of a support plate according to an embodiment of the present invention.
FIG. 6 is a cross-sectional view of another embodiment, taken along line I - I' of FIG. 1.
FIG. 7 is a plan view of a support plate according to an embodiment of the present invention.
FIG. 8 is a plan view of a display device according to an embodiment of the present invention.
FIG. 9 is a cross-sectional view taken along line II - II' of FIG. 8.
FIG. 10 is a plan view of a display device according to an embodiment of the present invention.
FIG. 11 is a cross-sectional view taken along line III - III' of FIG. 10.
FIG. 12 is a cross-sectional view of another embodiment, taken along line III - III' in FIG. 10.
FIG. 13 is a plan view of a display device according to an embodiment of the present invention.
FIG. 14 is a cross-sectional view taken along line IV - IV' of FIG. 13.
FIG. 15 is a perspective view of a reinforcement plate and a second adhesive layer according to an embodiment.
FIG. 16 is a perspective view of a reinforcement plate according to an embodiment.
FIG. 17 is a cross-sectional view of an electronic device according to an embodiment of the present invention.

### DETAILED DESCRIPTION

Advantages and features of the present invention and methods to achieve them will become apparent from the descriptions of example embodiments hereinbelow with reference to the accompanying drawings. However, the present invention is not limited to example embodiments disclosed herein but may be implemented in various different ways. The example embodiments are provided for making the disclosure of the present invention thorough and for fully conveying the scope of the present invention to those skilled in the art. It is to be noted that the scope of the present invention as defined by the claims is not limited thereto.

As used herein, a phrase "an element A on an element B" refers to that the element A may be disposed directly on the element B and/or the element A may be disposed indirectly on the element B via another element C. Like reference numerals denote like elements throughout the descriptions. The figures, dimensions, ratios, angles, numbers of elements given in the drawings are illustrative examples and are not limiting.

The term "substantially," as used herein, means approximately or actually. The term "substantially identical" means approximately or actually identical. The term "substantially the same" means approximately or actually the same.

Although terms such as first, second, and the like are used to distinguish arbitrarily between the elements such terms describe, and thus these terms are not necessarily intended to indicate temporal or other prioritization of such elements. These terms are used to distinguish one element from another. Accordingly, as used herein, a first element may be a second element within the technical scope of the present invention.

Features of various example embodiments of the present invention may be combined partially or totally. As will be clearly appreciated by those skilled in the art, technically various interactions and operations are possible. Various example embodiments can be practiced individually or in combination.

Hereinafter, example embodiments of the present invention will be described with reference to the accompanying drawings.

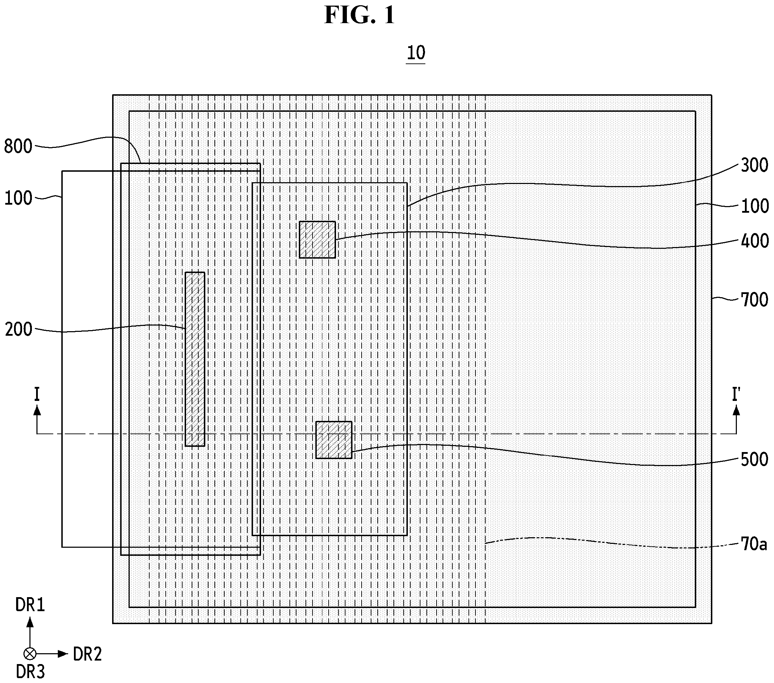

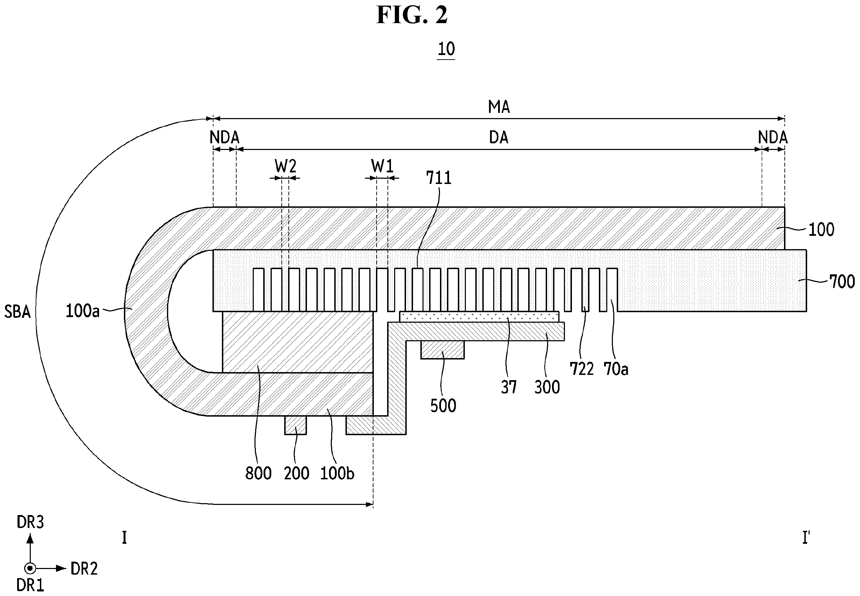

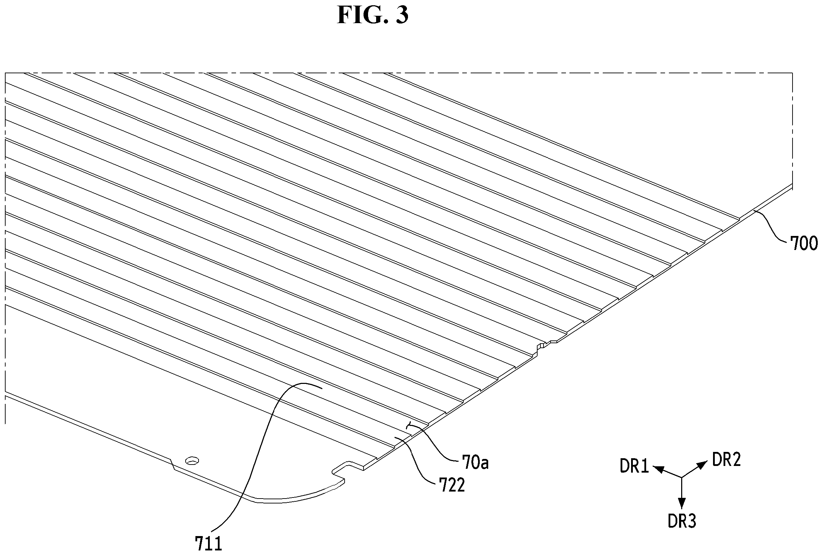

FIG. 1 is a plan view of a display device according to an embodiment of the present invention. FIG. 2 is a cross-sectional view taken along line I - I' of FIG. 1. FIG. 3 is a perspective view of a part of a support plate 700 of FIGS. 1 and 2.

Referring to FIGS. 1 and 2, a display device 10 may be employed by portable electronic devices such as, for example, a mobile phone, a smart phone, a tablet PC, a mobile communications terminal, an electronic notebook, an electronic book, a portable multimedia player (PMP), a navigation device and an ultra-mobile PC (UMPC). For example, the display device 10 may be used as a display unit of a television, a laptop computer, a monitor, an electronic billboard, or the Internet of Things (IOT). In another example, the display device 10 may be applied to wearable devices such as, for example, a smart watch, a watch phone, a glasses-type display, and a head-mounted display (HMD) device.

The display device 10 may have a shape similar to a quadrangular shape when viewed from the top. For example, the display device 10 may have a shape similar to a rectangle having shorter sides in a first direction DR1 and longer sides in a second direction DR2. The corners where the shorter sides in the first direction DR1 meet the longer sides in the second direction DR2 may be rounded with a predetermined curvature or may be a right angle. The shape of the display device 10 when viewed from the top is not limited to a quadrangular shape, but may be formed in a shape similar to other polygonal shapes, a circular shape, or an elliptical shape.

The display device 10 may include a display panel 100, a driver circuit (e.g., a display driver 200), a circuit board 300, and an intermediate board 600. The driver circuit may be also termed as a second driver circuit 200. However, the invention is not restricted to the embodiment in which the second driver circuit 200 is a display driver, but the second driver circuit may also be another kind of driver circuit, e.g. touch driver or a powers supply unit or even another driver circuit.

The display panel 100 may include a main area MA and a subsidiary area SBA.

The main area MA of the display panel 100 may include a display area DA having pixels for displaying images, and a non-display area NDA around the display area DA. The display area DA may output lights from a plurality of emission areas or a plurality of open areas. For example, the display panel 100 may include a pixel circuit including switching elements, a pixel-defining layer that defines the emission areas or the open areas, and a self-light-emitting element.

For example, the self-light-emitting element may include, but is not limited to, at least one of: an organic light-emitting diode including an organic emissive layer, a quantum-dot light-emitting diode (quantum LED) including a quantum-dot emissive layer, an inorganic light-emitting diode (inorganic LED) including an inorganic semiconductor, and a micro light-emitting diode (micro LED).

The non-display area NDA may be located on the outer side of the display area DA. The non-display area NDA may be defined as the edge of the main area MA of the display panel 100. The non-display area NDA may include a gate driver (not illustrated) that applies gate signals to gate lines, and fan-out lines (not illustrated) that connect the display driver 200 with the display area DA.

The subsidiary area SBA may extend from one side of the main area MA. The subsidiary area SUB may include a flexible material that can be bent, folded, or rolled. In an example in which the subsidiary area SBA is bent, the subsidiary area SBA may overlap with the main area MA in the thickness direction (e.g., third direction DR3). The subsidiary area SBA may include pads connected to the display driver 200 and the circuit board 300.

The subsidiary area SBA may include a bending area 100a and a mounting area 100b.

The bending area 100a may be located between the main area MA and the mounting area 100b. One side of the bending area 100a may be in contact with the main area MA, and the opposite side of the bending area 100a may be in contact with the mounting area 100b. The bending area 100a may have a U-shape (or a U-shaped cross section) that protrudes in the opposite direction of the second direction DR2. The main area MA and the mounting area 100b may be connected by the bending area 100a.

One side of the mounting area 100b may be in contact with the bending area 100a. In an example in which the display panel 100 is bent, the mounting area 100b may be located on the lower side of the main area MA. For example, the mounting area 100b may be located below the main area MA such that the mounting area 100b overlaps with the main area MA in the third direction DR3. According to an embodiment of the present invention, the mounting area 100b may overlap with the non-display area NDA and a part of the display area DA adjacent to the bending area 100a in the third direction DR3.

As described herein, the display panel 100 has a bent shape due to the bending area, and this bent display panel may have a U-shape (or a U-shaped cross section). Herein, the surface of the bent display panel 100 on which images are displayed is defined as the outer surface of the display panel 100, while the surface opposite to the outer surface of the display panel 100 is defined as the inner surface of the display panel 100.

The display driver 200 may output signals and voltages for driving the display panel 100. The display driver 200 may supply data voltages to data lines. The display driver 200 may apply a supply voltage to a voltage line and may supply gate control signals to the gate driver. The display driver 200 may be implemented as an integrated circuit (IC) and may be attached on the display panel 100 by a chip-on-glass (COG) technique, a chip-on-plastic (COP) technique, or ultrasonic bonding. For example, the display driver 200 may be disposed in the subsidiary area SBA and may overlap with the main area MA in the thickness direction (third direction DR3) as the subsidiary area SBA is bent. According to an embodiment of the present invention, the display driver 200 described herein may be disposed in the mounting area 100b of the subsidiary area SBA. In another example, the display driver 200 may be mounted on the circuit board 300.

The circuit board 300 may be connected to the display panel 100. For example, the circuit board 300 may be electrically connected to the display panel 100 through a conductive adhesive member. For example, a terminal of the circuit board 300 may be physically and electrically connected to a pad disposed in the mounting area 100b of the display panel 100 through a conductive adhesive member. The conductive adhesive member may be, for example, an anisotropic conductive film (ACF).

According to an embodiment of the present invention, the circuit board 300 may be, for example, a flexible printed circuit board (FPCB), a printed circuit board (PCB), or a flexible film such as, for example, a chip-on-film (COF).

At least a part of the circuit board 300 may overlap with the sub-area SBA of the display panel 100 in the third direction DR3. In an example in which the display panel 100 is bent, at least a part of the circuit board 300 may overlap with the mounting area 100b of the sub-area SBA in the third direction DR3. According to an embodiment of the present invention, the circuit board 300 may overlap with the display driver 200 in the third direction DR3.

Due to the level difference between the mounting area 100b of the display panel 100 and the support plate 700, the circuit board 300 connected to the display panel 100 and disposed on the support plate 700 has a bent shape.

A driver circuit such as, for example, a touch driver 400 and a power supply unit 500 may be disposed on the circuit board 300. For example, the touch driver 400 and the power supply unit 500 may be mounted on the circuit board 300. The driver circuit may be also termed as a first driver circuit 400, 500. However, the invention is not restricted to the embodiment in which the first driver circuit 400, 500 is a touch driver or a powers supply unit, or one first driver circuit 400 is a touch driver and another first driver circuit 500 is a power supply unit, but the first driver circuit may also be another kind of driver circuit, e.g. a display driver or even another driver circuit.

The touch driver 400 may be electrically connected to a touch sensing unit of the display panel 100. The touch driver 400 may supply a touch driving signal to a plurality of touch electrodes of the touch sensing unit and may sense a change in the capacitance between the plurality of touch electrodes. For example, the touch driving signals may be pulse signals having a predetermined frequency. The touch driver 400 may determine whether there is an input and may find the coordinates of the input based on the amount of the change in the capacitance between the touch electrodes. The touch driver 400 may be implemented as an integrated circuit (IC).

The power supply unit 500 may apply supply voltages to the display driver 200 and the display panel 100. The power supply unit 500 may generate and supply a driving voltage to a driving voltage line, may generate and supply an initializing voltage to an initialization voltage line, and may generate and supply a common voltage to a common electrode shared by light-emitting elements of a plurality of pixels. For example, the driving voltage may be a high-level voltage for driving the light-emitting element, and the common voltage may be a low-level voltage for driving the light-emitting element.

A reinforcement plate 800 may be disposed between the main area MA and the mounting area 100b of the display panel 100. One end of the reinforcement plate 800 may face the bending area 100a of the display panel 100. The reinforcement plate 800 may include a metal material. For example, the reinforcement plate 800 may be formed of a material including at least one of stainless steel, aluminum (Al), and copper (Cu). An adhesive layer for attaching the reinforcement plate 800 to the display panel 100 may be further disposed between the reinforcement plate 800 and the display panels 100 (e.g., the portion corresponding to the mounting area 100b of the display panel 100).

The support plate 700 may be disposed between the main area MA and the mounting area 100b of the display panel 100. For example, the support plate 700 may be disposed between the main area MA of the display panel 100 and the reinforcement plate 800 described herein. One end of the support plate 700 may face the bending area 100a of the display panel 100. An adhesive layer for attaching the support plate 700 to the reinforcement plate 800 may be further disposed between the support plate 700 and the reinforcement plate 800. An adhesive layer for attaching the support plate 700 to the display panel 100 may be further disposed between the support plate 700 and the display panel 100 (e.g., the portion corresponding to the display area DA of the display panel 100).

As illustrated in FIGS. 1 and 2, the support plate 700 may have an area larger than the main area MA of the display panel 100. The support plate 700 may include a metal material. For example, the support plate 700 may be formed of a material including at least one of stainless steel, aluminum (Al), and copper (Cu).

The support plate 700 may have a passage (or air passage). In other words, the support plate 700 may have a passage in the form of a groove 70a. For example, the support plate 700 may have at least one groove 70a corresponding to at least one passage. According to an embodiment, the support plate 700 may have a plurality of grooves 70a. Each groove 70a may have a recessed shape along the thickness direction of the support plate 700. For example, as illustrated in FIGS. 2 and 3, the groove 70a may have a recessed shape in the third direction DR3 from the lower surface of the support plate 700. In an example in which a plurality of grooves 70a is located in the lower surface of the support plate 700 in this way, the lower surface of the support plate 700 where the grooves 70a are located may have a pattern of peaks and valleys (i.e., ups and downs).

The grooves 70a of the support plate 700 may overlap with at least one driver circuit on the circuit board 300. For example, as illustrated in FIGS. 1 and 2, the grooves 70a may overlap with the touch driver 400 and the power supply unit 500. In some aspects, the grooves 70a may overlap with the display driver 200 disposed in the mounting area 100b of the display panel 100.

In the plan view of FIG. 1, the grooves 70a may extend in the first direction DR1. The grooves 70a extended in the first direction DR1 may penetrate the support plate 700 from one side surface to the opposite side surface. For example, each groove 70a may have two ends, and both ends of the grooves 70a in the first direction DR1 may penetrate the support plate 700 on one surface and the opposing surface in the first direction DR1, respectively. Specifically, one end of each of the grooves 70a may penetrate one surface of the support plate 700 in the first direction DR1, while an opposite end of each of the grooves 70a may penetrate the opposite surface the support plate 700 in the opposite direction of the first direction DR1 (hereinafter referred to as a first opposite direction).

As illustrated in FIG. 1, the plurality of grooves 70a may be arranged in the second direction DR2 that intersects the first direction DR1. The grooves 70a may be equally spaced apart from one another.

The width W1 of the grooves 70a may be different from the width W2 of sidewalls 722 between adjacent grooves 70a. For example, the grooves 70a may be defined by the adjacent sidewalls 722 and a bottom 711 (also referred to herein as a bottom portion) of the support plate 700, and thus the width W1 of the grooves 70a may be greater than the width W2 of the sidewalls 722. It should be understood, however, that the embodiments of the present invention are not limited thereto. The width W1 of the grooves 70a may be equal to the width W2 of the sidewalls 722. Alternatively, the width W1 of the grooves 70a may be smaller than the width W2 of the sidewalls 722.

An adhesive layer 37 may be disposed between the circuit board 300 and the support plate 700. The adhesive layer 37 may attach the circuit board 300 to the support plate 700. For example, a surface of the adhesive layer 37 may be attached to the circuit board 300, and the opposite surface of the adhesive layer 37 may be attached to the sidewalls 722 of the support plate 700. The adhesive layer 37 may include a double-sided tape.

In the cross-sectional view illustrated in FIG. 2, a driver circuit on the circuit board 300 may be disposed closer to the support plate 700 (or the grooves 70a of the support plate 700) than a driver circuit on the display panel 100. For example, the power supply unit 500 (or the touch driver 400) may be disposed closer to the support plate 700 (or the grooves 70a of the support plate 700) in the third direction DR3 than the display driver 200.

According to an embodiment, since the support plate 700 has a plurality of grooves 70a as passages (e.g., air passages), the contact area between the passages of the support plate 700 and the air can increase. Accordingly, heat from the driver circuit can be dissipated more efficiently.

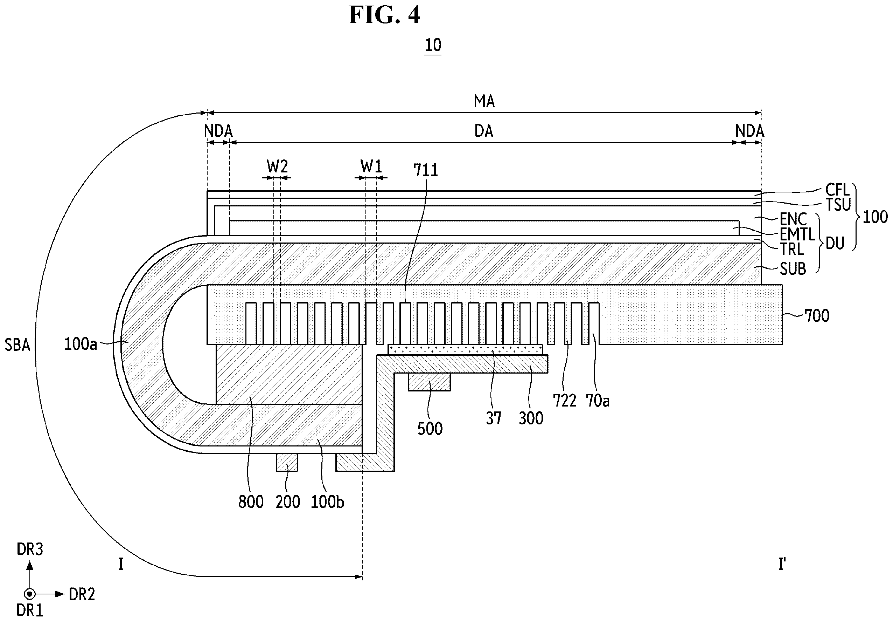

FIG. 4 is a view for illustrating the display panel 100 of FIG. 2.

Referring to FIG. 4, the display panel 100 may include a display unit DU, a touch sensing unit TSU, and a color filter layer CFL. The display unit DU may include a substrate SUB, a transistor layer TRL, an emission material layer EMTL, and an encapsulation layer ENC.

The substrate SUB may be a base substrate or a base member. The substrate SUB may be a flexible substrate that can be bent, folded, or rolled. For example, the substrate SUB may include, but is not limited to, a polymer resin such as, for example, polyimide PI. In another example, the substrate SUB may include a glass material or a metal material.

The transistor layer TRL may be disposed on the substrate SUB. The transistor layer TRL may include a plurality of thin-film transistors forming pixel circuits of pixels. The transistor layer TRL may include gate lines, data lines, voltage lines, gate control lines, fan-out lines for connecting the display driver 200 with the data lines, lead lines for connecting the display driver 200 with the pads, and other lines or components. Each of the thin-film transistors may include a semiconductor region, a source electrode, a drain electrode, and a gate electrode. In an example in which the gate driver is formed on one side of the non-display area NDA of the display panel 100, the gate driver may include thin-film transistors.

The transistor layer TRL may be disposed in the display area DA, the non-display area NDA, and the subsidiary area SBA. Thin-film transistors, gate lines, data lines and voltage lines in the thin-film transistor layer TRL for the pixels may be disposed in the display area DA. The gate control lines and the fan-out lines in the transistor layer TRL may be disposed in the non-display area NDA. The lead lines of the transistor layer TRL may be disposed in the subsidiary area SBA. The display driver 200, the conductive adhesive member and the intermediate board 600 may be disposed on the transistor layer.

The emission material layer EMTL may be disposed on the transistor layer TRL. The emission material layer EMTL may include a plurality of light-emitting elements in each of which a pixel electrode, an emissive layer, and a common electrode are stacked on one another sequentially to emit light, and a pixel-defining film for defining the pixels. The plurality of light-emitting elements in the emission material layer EMTL may be disposed in the display area DA.

For example, the emissive layer may be an organic light-emitting layer containing an organic material. The emissive layer may include a hole transporting layer, an organic light-emitting layer and an electron transporting layer. In an example in which the pixel electrode receives a voltage and the common electrode receives a cathode voltage through the thin-film transistor in the transistor layer TRL, the holes and electrons may move to the organic light-emitting layer through the hole transporting layer and the electron transporting layer, respectively, such that they combine in the organic light-emitting layer to emit light. For example, the pixel electrode may be an anode electrode while the common electrode may be a cathode electrode. It is, however, to be understood that embodiments of the present invention are not limited thereto.

As another example, the light-emitting elements may include quantum-dot light-emitting diodes each including a quantum-dot emissive layer, inorganic light-emitting diodes each including an inorganic semiconductor, or micro light-emitting diodes.

The encapsulation layer ENC may cover the upper and side surfaces of the emission material layer EMTL, and can protect the emission material layer EMTL. The encapsulation layer ENC may include at least one inorganic film and at least one organic film for encapsulating the emission material layer EMTL.

The touch sensing unit TSU may be disposed on the encapsulation layer ENC. The touch sensing unit TSU may include a plurality of touch electrodes for sensing a user's touch by capacitive sensing, and touch lines connecting the plurality of touch electrodes with the touch driver 400. For example, the touch sensing unit TSU may sense a user's touch by mutual capacitance sensing or self-capacitance sensing.

In another example, the touch sensing unit TSU may be disposed on a separate substrate disposed on the display unit DU. In such case, the substrate supporting the touch sensing unit TSU may be a base member encapsulating the display unit DU.

The plurality of touch electrodes of the touch sensing unit TSU may be disposed in a touch sensor area overlapping the display area DA. The touch lines of the touch sensing unit TSU may be disposed in a touch peripheral area overlapping the non-display area NDA.

The color filter layer CFL may be disposed on the touch sensing unit TSU. The color filter layer CFL may include a plurality of color filters associated with the plurality of emission areas, respectively. Each of the color filters may selectively transmit light of a particular wavelength and block or absorb lights of other wavelengths. The color filter layer CFL may absorb some of lights introduced from the outside of the display device 10 to reduce the reflection of external light. Accordingly, the color filter layer CFL can prevent distortion of colors due to the reflection of external light.

Since the color filter layer CFL is disposed directly on the touch sensing unit TSU, the display device 10 may be implemented without a separate substrate for the color filter layer CFL. Therefore, the thickness of the display device 10 can be relatively reduced.

The subsidiary area SBA of the display panel 100 may extend from one side of the main area MA. The subsidiary area SUB may include a flexible material that can be bent, folded, or rolled. In an example in which the subsidiary area SBA is bent, the subsidiary area SBA may overlap with the main area MA in the thickness direction (third direction DR3). The subsidiary area SBA may include pads electrically connected to the display driver 200 and the circuit board 300.

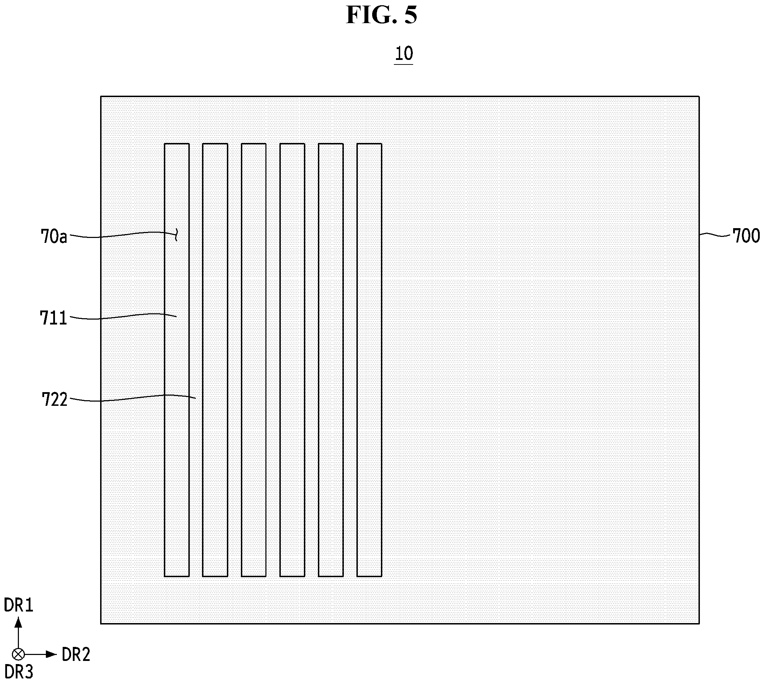

FIG. 5 is a plan view of a support plate 700 according to an embodiment.

As illustrated in FIG. 5, grooves 70a of the support plate 700 may be surrounded by sidewalls 722 when viewed from the top (e.g., when viewed in the third direction D3). In other words, when viewed from the top, both ends of the grooves 70a opposing each other in the first direction DR1 may not penetrate the surfaces of the support plate 700 opposing each other in the first direction DR1, but may be enclosed by the sidewalls 722.

The grooves 70a of the support plate 700 of FIG. 5 may be replaced with the grooves 70a of the support plate 700 of FIG. 1 described herein.

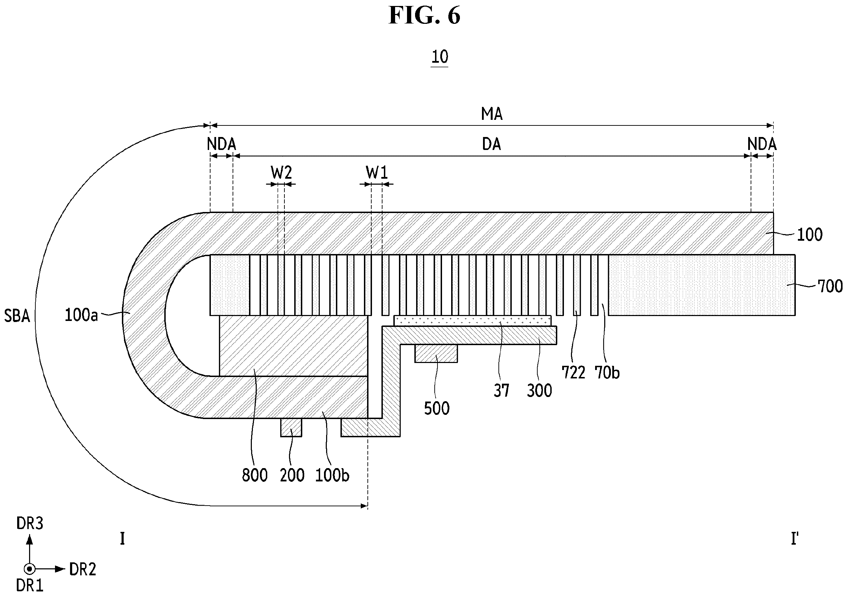

FIG. 6 is a cross-sectional view of another embodiment, taken along line I - I' of FIG. 1.

A display device 10 of FIG. 6 is different from the display device 10 of FIG. 2 in that a support plate 700 includes a hole 70b instead of a groove 70a. The following description will focus on the difference.

As illustrated in FIG. 6, the support plate 700 may include a hole 70b penetrating the support plate 700 in the thickness direction. For example, the support plate 700 may include a plurality of holes 70b penetrating the support plate 700 in the third direction DR3. The holes 70b may be defined by being surrounded by sidewalls 722 of the support plate 700. The width of the holes 70b may be different from the width of sidewalls 722 between adjacent holes 70b.

In the cross-sectional view illustrated in FIG. 6, a driver circuit on the circuit board 300 may be disposed closer to the support plate 700 (or the holes 70b of the support plate 700) than a driver circuit on the display panel 100. For example, the power supply unit 500 (or the touch driver 400) may be disposed closer to the support plate 700 (or the holes 70b of the support plate 700) in the third direction DR3 than the display driver 200.

According to an embodiment, since the support plate 700 has a plurality of holes 70b as passages (e.g., air passages), the contact area between the passages of the support plate 700 and the air can increase. Accordingly, heat from the driver circuits can be dissipated more efficiently.

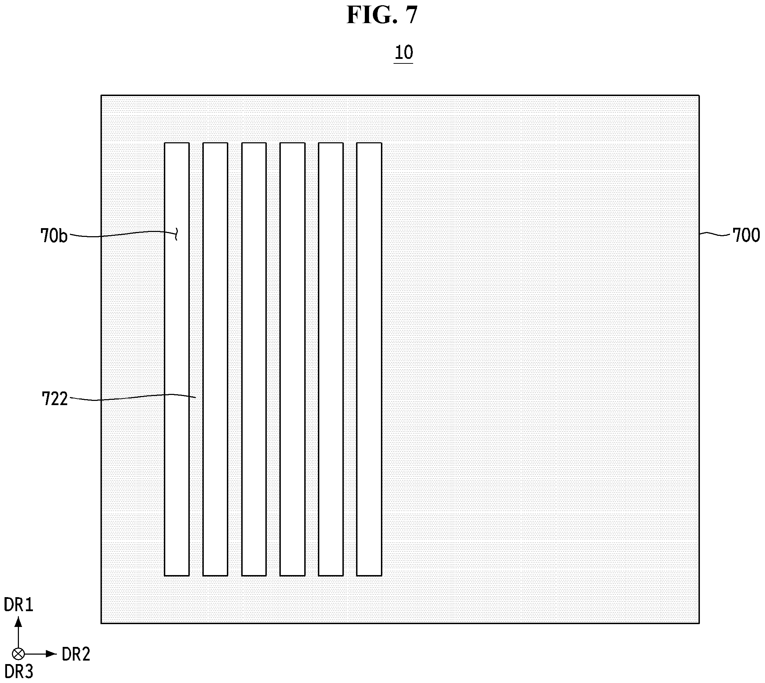

FIG. 7 is a plan view of the support plate 700 according to an embodiment.

As illustrated in FIG. 7, the support plate 700 may have a passage (or air passage). In other words, the support plate 700 may have a passage in the form of a hole 70b. For example, the support plate 700 may have at least one hole 70b corresponding to at least one passage.

The hole 70b of the support plate 700 may penetrate the support plate 700 in the third direction DR3. The hole 70b of the support plate 700 may be surrounded by sidewalls 722 of the support plate 700.

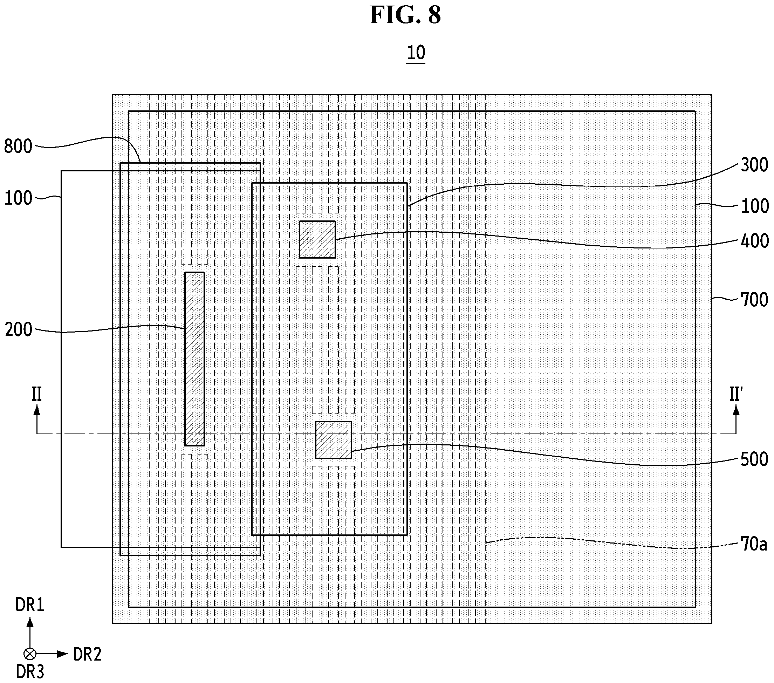

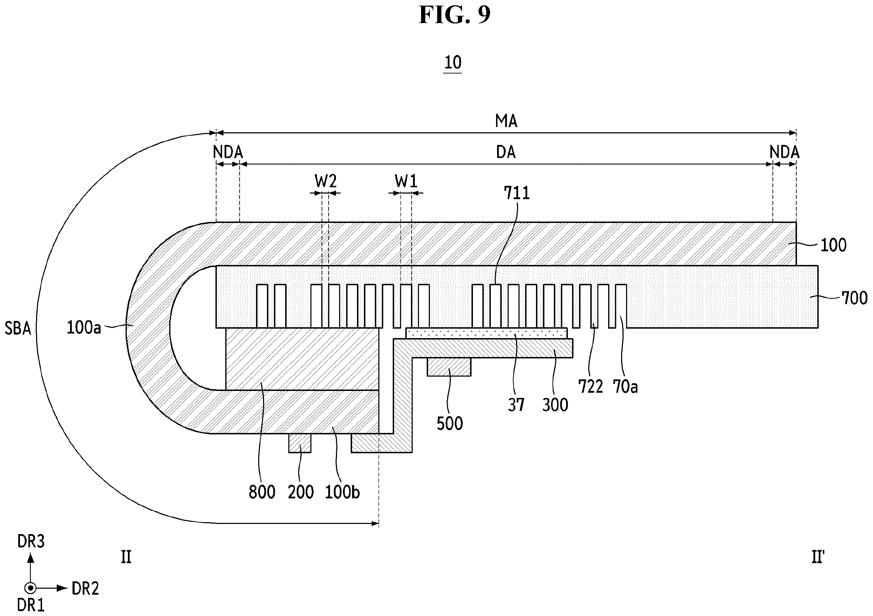

FIG. 8 is a plan view of a display device according to an embodiment of the present invention. FIG. 9 is a cross-sectional view taken along line II - II' of FIG. 8.

The display device 10 of FIGS. 8 and 9 is different from the display device 10 of FIGS. 1 and 2 in that grooves 70a of a support plate 700 do not overlap with driver circuits but are disposed adjacent to the driver circuits (e.g., when viewed in the third direction DR3). The following description will focus on the difference.

The support plate 700 may have a passage (or air passage). In other words, as illustrated in FIGS. 8 and 9, the support plate 700 may have a passage in the form of a groove 70a. For example, the support plate 700 may have at least one groove 70a corresponding to at least one passage.

As illustrated in FIGS. 8 and 9, the grooves 70a of the support plate 700 may be located adjacent to the driver circuits. For example, the grooves 70a may be located around each of a display driver 200, a power supply unit 500, and a touch driver 400. For example, in the plan view of FIG. 8, the driver circuits (e.g., the display driver 200, the power supply unit 500 and the touch driver 400) may be surrounded by adjacent grooves 70a (e.g., when viewed in the third direction DR3).

According to an embodiment, as illustrated in FIGS. 8 and 9, the sidewalls 722 of the support plate 700 that defines the grooves 70a of the support plate 700 may overlap with the driver circuits and may further optionally be aligned with the driver circuits. For example, each of the display driver 200, the power supply unit 500 and the touch driver 400 may overlap with the sidewalls 722 of the support plate 700 and may further optionally be aligned with the sidewalls 722. For example, the driver circuits may overlap with the sidewalls 722. In other words, the driver circuits may overlap with the sidewalls 722 but not with the grooves 70a.

In the cross-sectional view illustrated in FIG. 9, a driver circuit on the circuit board 300 may be disposed closer to the support plate 700 (or the sidewalls 722 of the support plate 700) than a driver circuit on the display panel 100. For example, the power supply unit 500 (or the touch driver 400) may be disposed closer to the support plate 700 (or the sidewalls 722 of the support plate 700) in the third direction DR3 than the display driver 200.

It should be noted that both ends of the grooves 70a of FIGS. 8 and 9 may be enclosed by the sidewalls 722 as illustrated in FIG. 5, for example, when viewed from the top.

In some aspects, the support plate 700 of FIGS. 8 and 9 may have the holes 70b illustrated in FIGS. 6 and 7 described herein instead of the grooves 70a. In this instance, the holes 70b of the support plate 700 may not overlap with the driver circuits (e.g., the display driver 200, the touch driver 400 and the power supply unit 500) but may overlap with the sidewalls 722 defining the holes 70b.

According to an embodiment, since the support plate 700 has a plurality of grooves 70a as passages (e.g., air passages), the contact area between the passages of the support plate 700 and the air can increase. Accordingly, heat from the driver circuit can be dissipated more efficiently.

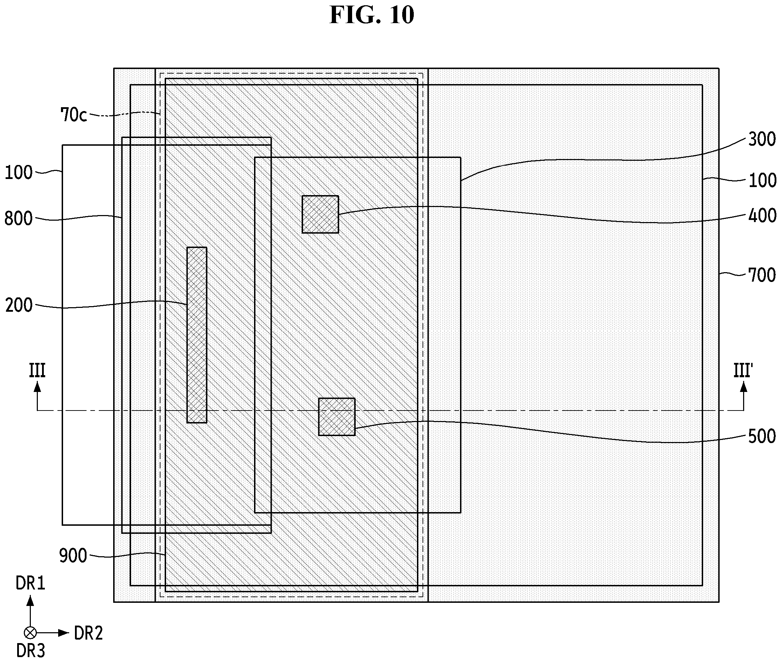

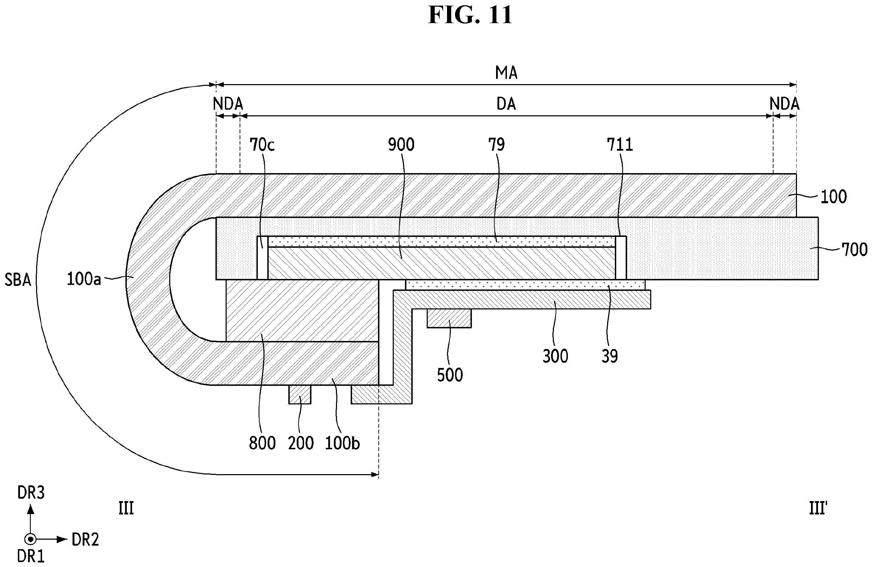

FIG. 10 is a plan view of a display device according to an embodiment of the present invention. FIG. 11 is a cross-sectional view taken along line III - III' of FIG. 10.

The display device 10 of FIGS. 10 and 11 is different from the display device 10 of FIGS. 1 and 2 in terms of a support plate 700 and a heat dissipation member 900. The following description will focus on the difference.

The display device 10 according to an embodiment may further include a heat dissipation member 900.

The support plate 700 may have a passage (or air passage). In other words, the support plate 700 may have a passage in the form of a groove 70c. For example, the support plate 700 may have at least one groove 70c corresponding to at least one passage. The groove 70c may have a recessed shape along the thickness direction of the support plate 700. For example, as illustrated in FIGS. 10 and 11, the groove 70c may have a recessed shape in the third direction DR3 from the lower surface of the support plate 700.

The heat dissipation member 900 may be disposed in the groove 70c. The groove 70c may be defined by sidewalls 722 and a bottom 711 of the support plate 700, and the heat dissipation member 900 may be surrounded by the sidewalls 722. For example, as illustrated in FIG. 10, the heat dissipation member 900 may be surrounded by the sidewalls 722 in the groove 70c. The heat dissipation member 900 may be in contact with the bottom 711 of the support plate 700 in the groove 70c. The heat dissipation member 900 may be attached to the bottom 711 of the support plate 700. To this end, according to an embodiment, a first adhesive layer 79 may be further disposed between the bottom 711 of the support plate 700 and the heat dissipation member 900 in the groove 70c. For example, a surface of the first adhesive layer 79 may be attached to the bottom 711 of the support plate 700, and the opposite surface of the first adhesive layer 79 may be attached to the heat dissipation member 900.

The heat dissipation member 900 may overlap with a reinforcement plate 800 and a circuit board 300. One side of the heat dissipation member 900 may be in contact with the reinforcement plate 800, and the opposite side of the heat dissipation member 900 may be in contact with the circuit board 300.

A second adhesive layer 39 may be disposed between the heat dissipation member 900 and the circuit board 300 to attach the heat dissipation member 900 to the circuit board 300.

The heat dissipation member 900 may overlap with the driver circuits. For example, the heat dissipation member 900 may overlap with at least one of the display driver 200, the power supply unit 500 and the touch driver 400.

The heat dissipation member 900 may include a heat diffusion material. For example, the heat dissipation member 900 may be formed of a material including at least one of copper and graphite.

As illustrated in FIG. 10, the driver circuits may be surrounded by the groove 70c of the support plate 700 when viewed from the top. For example, the display driver 200, the power supply unit 500 and the touch driver 400 may be surrounded by the groove 70c of the support plate 700 when viewed from the top. In other words, the display driver 200, the power supply unit 500 and the touch driver 400 may be surrounded by the edge of the groove 70c of the support plate 700 when viewed from the top.

In the cross-sectional view illustrated in FIG. 11, a driver circuit on the circuit board 300 may be disposed closer to the heat dissipation member 900 than a driver circuit on the display panel 100. For example, the power supply unit 500 (or the touch driver 400) may be disposed closer to the heat dissipation member 900 in the third direction DR3 than the display driver 200.

According to an embodiment, the heat dissipation efficiency of the support plate 700 can be further improved by disposing the heat dissipation member 900 in the passage (e.g., the groove 70c) of the support plate 700. In some aspects, the thickness of the display device 10 is not increased even though the heat dissipation member 900 is added because the heat dissipation member 900 is disposed in the groove 70c of the support plate 700.

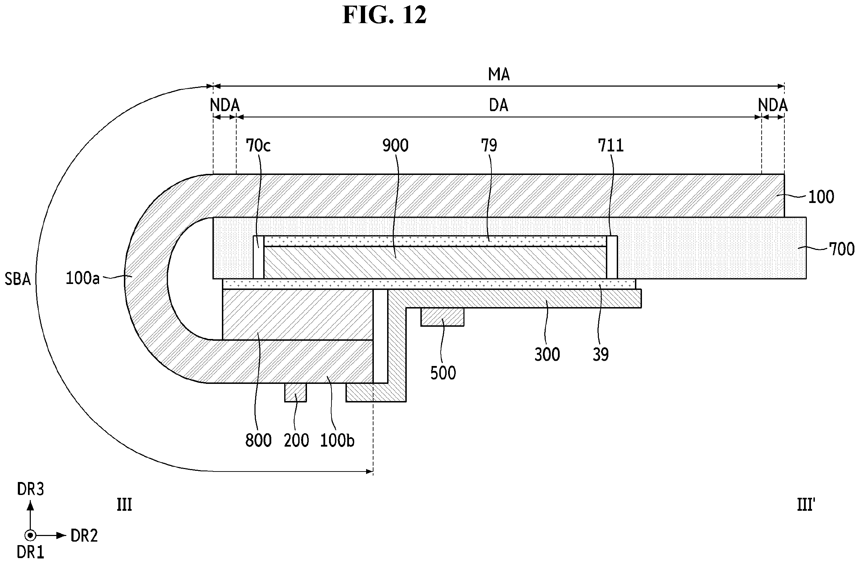

FIG. 12 is a cross-sectional view of another embodiment, taken along line III - III' of FIG. 10.

A display device 10 of FIG. 12 is different from the display device 10 of FIG. 11 that the display device 10 further includes in a second adhesive layer 39. The following description will focus on the difference.

As illustrated in FIG. 12, the second adhesive layer 39 disposed on the lower surface of a heat dissipation member 900 may be attached to a reinforcement plate 800 and a circuit board 300. For example, a surface of the second adhesive layer 39 may be attached to the heat dissipation member 900, and the opposite surface of the second adhesive layer 39 may be attached to the reinforcement plate 800 and the circuit board 300.

The surface of the second adhesive layer 39 may be further attached to the support plate 700.

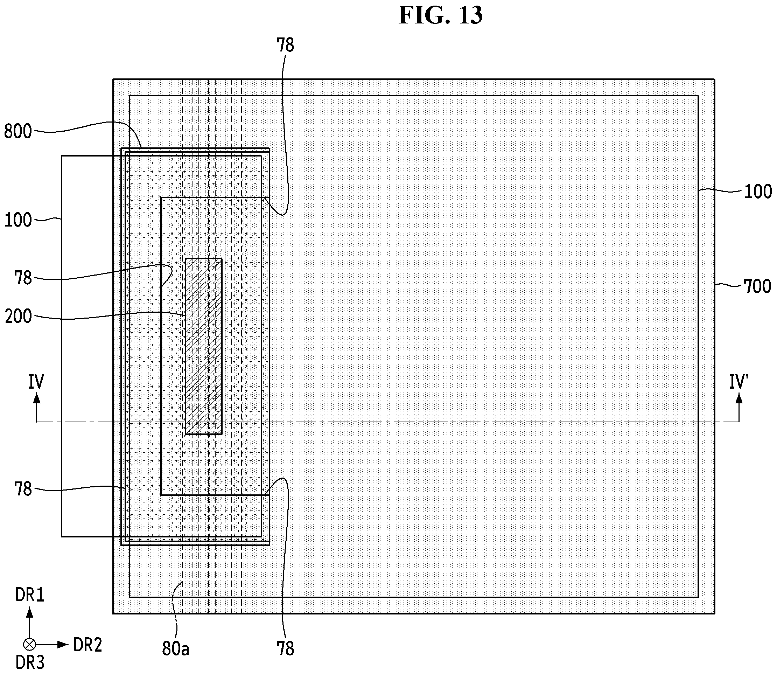

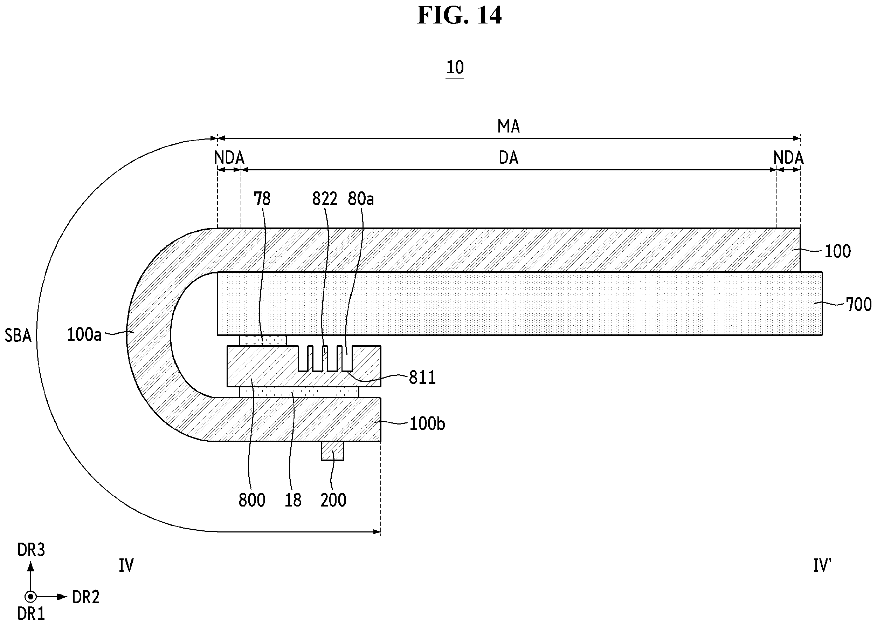

FIG. 13 is a plan view of a display device according to an embodiment of the present invention. FIG. 14 is a cross-sectional view taken along line IV - IV' of FIG. 13.

As illustrated in FIGS. 13 and 14, the support plate 700 and the reinforcement plate 800 may be disposed between the main area MA and the mounting area 100b of the display panel 100. For example, the reinforcement plate 800 may be disposed between the mounting area 100b of the display panel 100 and the support plate 700, and the support plate 700 may be disposed between the reinforcement plate 800 and the main area MA of the display panel 100.

A first adhesive layer 18 may be disposed between the mounting area 100b of the display panel 100 and the reinforcement plate 800. The first adhesive layer 18 may attach the display panel 100 to the reinforcement plate 800. The first adhesive layer 18 may also be termed as a lower adhesive layer.

A second adhesive layer 78 may be disposed between the reinforcement plate 800 and the support plate 700. The second adhesive layer 78 may attach the reinforcement plate 800 to the support plate 700. The second adhesive layer 78 may also be termed as an upper adhesive layer. Further, the numeration of the adhesive layers 18, 78 may be selected differently. For example, the adhesive layer 78 may be termed as the first adhesive layer, and the adhesive layer 18 may be termed as the second adhesive layer.

The reinforcement plate 800 may have a passage (or air passage). In other words, the reinforcement plate 800 may have a passage in the form of a groove 80a. For example, the reinforcement plate 800 may have at least one groove 80a corresponding to at least one passage. According to an embodiment, the reinforcement plate 800 may have a plurality of grooves 80a. The groove 80a may have a recessed shape along the thickness direction of the reinforcement plate 800. For example, as illustrated in FIG. 14, the groove 80a may have a recessed shape in the opposite direction of the third direction DR3 (hereinafter referred to as a third opposite direction) from the upper surface of the reinforcement plate 800. In an example in which a plurality of grooves 80a is located in the lower surface of the reinforcement plate 800 in this way, the upper surface of the reinforcement plate 800 where the grooves 80a are located may have a pattern of peaks and valleys (i.e., ups and downs).

The groove 80a of the reinforcement plate 800 may be defined by sidewalls 822 and a bottom 811 of the reinforcement plate 800. As the grooves 70a and the sidewalls 722 of the support plate 700 of FIG. 2 described herein may have different widths, the grooves 80a and the sidewalls 822 of the reinforcement plate 800 may have different widths. For example, the width of the grooves 80a of the reinforcement plate 800 may be larger than the width of the sidewalls 822 of the reinforcement plate 800. Alternatively, the width of the grooves 80a of the reinforcement plate 800 may be equal to the width of the sidewalls 822 of the reinforcement plate 800. Alternatively, the width of the grooves 80a of the reinforcement plate 800 may be smaller than the width of the sidewalls 822 of the reinforcement plate 800.

According to an embodiment, the second adhesive layer 78 may be disposed on the upper surface of the reinforcement plate 800 such that the second adhesive layer 78 does not overlap with the grooves 80a of the reinforcement plate 800.

It should be noted that the first adhesive layer 18 may overlap with the grooves 80a of the reinforcement plate 800. In some aspects, the first adhesive layer 18 may overlap with the second adhesive layer 78. The area of the first adhesive layer 18 may be greater than the area of the second adhesive layer 78 when viewed from the top.

In some aspects, the display driver 200 may overlap with the grooves 80a of the reinforcement plate 800.

According to an embodiment, since the reinforcement plate 800 has a plurality of grooves 80a as passages (e.g., air passages), the contact area between the passages of the reinforcement plate 800 and the air can increase. Accordingly, heat from the driver circuit can be dissipated more efficiently.

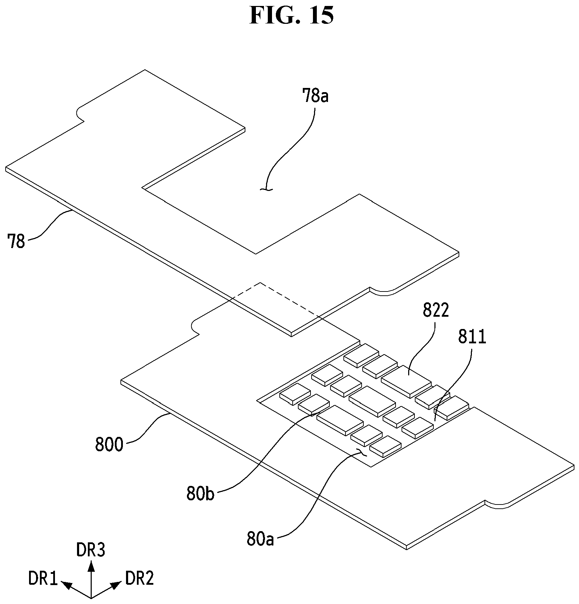

FIG. 15 is a perspective view of a reinforcement plate 800 and a second adhesive layer according to an embodiment.

The reinforcement plate 800 may have a groove 80a (hereinafter referred to as a main groove 80a) and an auxiliary groove 80b as the above-described passages.

The main groove 80a is substantially identical to the groove 70a of FIGS. 13 and 14 described herein; and, therefore, repeated descriptions of like elements are omitted for brevity.

The auxiliary groove 80b may extend in a direction intersecting the extension direction of the main groove 80a. For example, the main groove 80a may extend in the first direction DR1, and the auxiliary groove 80b may extend in the second direction DR2. The auxiliary groove 80b may connect the groove 70a with adjacent one.

The second adhesive layer 78 may be disposed on the reinforcement plate 800. The second adhesive layer 78 may be disposed on the upper surface of the reinforcement plate 800 such that the second adhesive layer 78 does not overlap with the main groove 80a or the auxiliary groove 80b. For example, the second adhesive layer 78 may have an open area 78a such that it does not overlap with the bottom 811 of the reinforcement plate 800 or the sidewalls 822 on the bottom 811. The open area 78a of the second adhesive layer 78 may overlap with the bottom 811 of the reinforcement plate 800, the main groove 80a, the auxiliary groove 80b and the sidewalls 822 (e.g., the sidewalls 822 on the bottom 811).

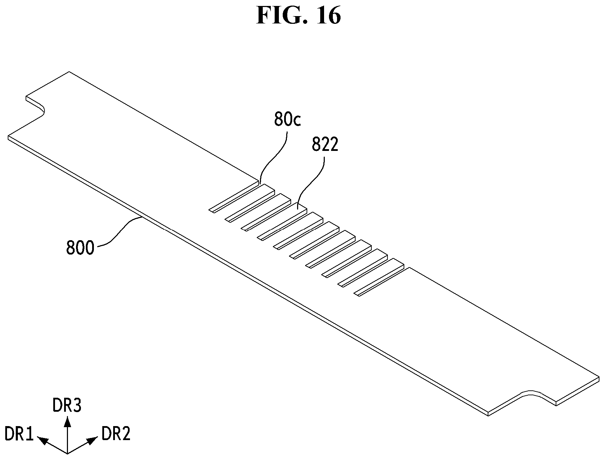

FIG. 16 is a perspective view of a reinforcement plate 800 according to an embodiment.

As illustrated in FIG. 16, the reinforcement plate 800 may have slits 80c penetrating the reinforcement plate 800 in the thickness direction of the reinforcement plate 800. For example, a plurality of slits 80c as the above-described passages may penetrate the reinforcement plate 800 in the third direction DR3. The slits 80c may extend in the second direction DR2. The slits 80c may extend in the second direction DR2 and penetrate a side surface of the reinforcement plate 800. In other words, the surface of the reinforcement plate 800 may be opened by the slits 80c.

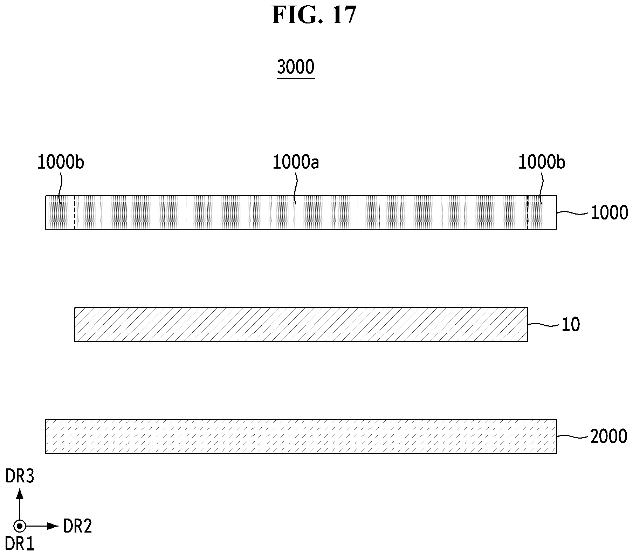

FIG. 17 is a cross-sectional view of an electronic device according to an embodiment of the present invention.

As illustrated in FIG. 17, an electronic device 3000 may include a bottom cover 2000, a display device 10, and a cover window 1000.

The bottom cover 2000 may form the bottom exterior of the electronic device 3000. The bottom cover 2000 may include plastic, metal or plastic and metal.

The display device 10 may be disposed on the bottom cover 2000. For example, the display device 10 may be disposed between the bottom cover 2000 and the cover window 1000. The display device 10 of FIG. 17 may be identical to one of the above-described display devices 10 illustrated in FIGS. 1 to 16.

The cover window 1000 may be disposed on the display device 10 and cover the upper surface of the display device 10. The cover window 1000 can protect the upper surface of the display device 10.

The cover window 1000 may include a light-transmitting area 1000a in line with the display panel 10, and a light-blocking area 1000b not in line with the display device 10. The light-blocking area 1000b may be opaque. Alternatively, the light-blocking area 1000b may be formed as a decoration layer having a pattern that can be displayed to a user when no image is displayed.

In concluding the detailed description, those skilled in the art will appreciate that many variations and modifications can be made to the example embodiments without substantially departing from the principles of the present invention. Therefore, the disclosed example embodiments of the present invention are used in a generic and descriptive sense and not for purposes of limitation.

## Claims

1. A display device (10) comprising:
a display panel (100);
a first driver circuit (400, 500) connected to the display panel (100); and
a support plate (700) overlapping with the display panel (100),
wherein the support plate (700) has a groove (70a, 70c) or a hole (70b) that overlaps with the first driver circuit (400, 500).
wherein the first driver circuit (400, 500) is disposed on the circuit board (300).

2. A display device (10) comprising:
a display panel (100);
a first driver circuit (400, 500) connected to the display panel (100); and
a support plate (700) overlapping with the display panel (100),
wherein the support plate (700) has a groove (70a, 70c) or a hole (70b) that is disposed around the first driver circuit (400, 500) when viewed from a top of the support plate (700).

3. The display device (10) of claim 2, wherein the first driver circuit (400, 500) overlaps with sidewalls (722) of the support plate (700).

4. The display device (10) of at least one of claims 1 to 3, wherein:
the groove (70a, 70c) or hole (70b) of the support plate (700) is defined by sidewalls (722) of the support plate (700) and a bottom (711) of the support plate (700), and
a width (W1) of the groove (70a, 70c) or hole (70b) of the support plate (700) is different from a width (W2) of the sidewalls (722) of the support plate (700).

5. The display device (10) of claim 4, wherein a width of the groove (70a, 70c) or hole (70b) of the support plate (700) is greater than a width of the sidewalls (722) of the support plate (700).

6. The display device (10) of claim 4, wherein a width of the groove (70a, 70c) or hole (70b) of the support plate (700) is smaller than a width of the sidewalls (722) of the support plate (700).

7. The display device (10) of at least one of claims 1 to 6, further comprising:
a second driver circuit (200) connected to the display panel (100),
wherein the groove (70a, 70c) or hole (70b) of the support plate (700) overlaps with the second driver circuit (200) or wherein the groove (70a, 70c) or hole (70b) of the support plate (700) is disposed around the second driver circuit (200) when viewed from a top of the support plate (700).

8. The display device (10) of at least one of claims 1 to 7, further comprising:
a circuit board (300) connected to the display panel (100),
wherein the first driver circuit (400, 500) is disposed on the circuit board (300).

9. The display device (10) of at least one of claims 1 or 4 to 8 when not dependent on claims 2 or 3, wherein
a heat dissipation member (900) is disposed in the groove (70c) or the hole (70b) of the support plate (700).

10. The display device (10) of claim 9, wherein an edge of the groove (70c) or hole (70b) of the support plate (700) surrounds the heat dissipation member (900) and the first driver circuit (400, 500) when viewed from a top of the support plate (700).

11. The display device (10) of claim 9 or 10, wherein the heat dissipation member (900) overlaps with the first driver circuit (400, 500).

12. The display device (10) of at least one of claims 9 to 11 when not dependent on claim 7, further comprising:
a second driver circuit (200) connected to the display panel (100),
wherein an edge of the groove (70c) or hole (70b) of the support plate (700) surrounds the first driver circuit (400, 500), the second driver circuit (200), and the heat dissipation member (900) when viewed from a top of the support plate (700).

13. The display device (10) of at least one of claims 9 to 12 when not dependent on claim 4, wherein:
the support plate (700) comprises sidewalls (722) and a bottom (711) defining the groove (70c) or hole (70b), and
the display device (10) further comprises a first adhesive layer (79) disposed between the heat dissipation member (900) and the bottom (711) of the support plate (700).

14. The display device (10) of claim 13 when not dependent on claim 8, further comprising:
a circuit board (300) connected to the display panel (100); and
a second adhesive layer (39) disposed between the heat dissipation member (900) and the circuit board (300),
wherein the first driver circuit (400, 500) is disposed on the circuit board (300).

15. The display device (10) of claim 14, further comprising a reinforcement plate (800) disposed between the support plate (700) and the display panel (100); and wherein the second adhesive layer (39) is further disposed between the reinforcement plate (800) and the heat dissipation member (900), wherein the second adhesive layer (39) is further disposed between the support plate (700) and the reinforcement plate (800) and between the support plate (700) and the circuit board (300).
